# EUROPEAN PATENT SPECIFICATION

(11) **EP 0 348 611 B1**
(45) Date of publication and mention of the grant of the patent: **20.07.1994**
(21) Application number: 89106438.8
(22) Date of filing: 11.04.1989
(51) Int. Cl.: H01J 1/34, H01J 37/073

(54) **Fibre optic photocathode**
Optische Faser-Photokathode
Photocathode à fibre optique

(30) Priority: 01.07.1988 US 214081
(43) Date of publication of application: 03.01.1990
(73) Proprietor: International Business Machines Corporation, Armonk, N.Y. 10504 (US)
(72) Inventor: Halbout, Jean-Marc, Larchmont, N.Y. 10538 (US); May, Paul G., New York, N.Y. 10027 (US)
(74) Representative: Schäfer, Wolfgang, Dipl.-Ing.

(56) References cited:
- GB-A- 2 157 884
- US-A- 4 868 380
- APPLIED PHYSICS LETTERS. vol. 44, no. 5, March 1984, NEW YORK US pages 565 - 566; Chunghsin Lee: "High current density photoemissive electron source"
- PATENT ABSTRACTS OF JAPAN vol. 3, no. 92 (E-128) 04 August 1979, & JP-A-54 069953
- JOURNAL OF THE OPTICAL SOCIETY OF AMERICA. vol. 56, no. 11, November 1966, NEW YORK US, pages 1568-1573; R.B.Cairns et al.: "Metal photocathodes as secondary standards for absolute intensity measurements in the vacuum ultraviolet"
- RCA TECHNICAL NOTES, TN 1184 16 June 1977, PRINCETON, NJ, US; J van Raalte: "Tunable cathode"

## Description

The invention is directed to cathodes that serve as electron sources in apparatus that employs a beam of electrons.

In electron beam apparatus, as the art has progressed, it has become apparent that with thermoionic and field emission types of cathodes or electron sources, the emission is subject to losses that operate to limit performance.

It is desirable that the emission pattern be as confined and directional as possible. In general, photoemission is more directional than thermionic emission, and it can be tailored by manipulation of the generating light beam.

Thermionic emission cathodes having arrangements for confining the emitted electron beam are in the art.

U.S. Patent 4,324,999 issued April 13, 1982 to Wolfe, entitled ELECTRON-BEAM CATHODE HAVING A UNIFORM EMISSION PATTERN, discloses an electron-beam cathode which emits electrons in a cone-shaped pattern in a forward direction whose electron density is substantially uniform throughout the cone. The cathode is comprised of a needle-shaped piece of single crystal tungsten having dopant atoms of zirconium and oxygen in the bulk thereof, and having only a single surface on the needle's tip. This cathode is formed by the steps providing a needle-shaped piece of single crystal tungsten having dopant atoms of zirconium and oxygen in the bulk thereof, and having a plurality of ring-shaped surfaces on the needle's tip; and subsequently transforming those surfaces into diagonally oriented planar surfaces by heating the needle in an atmosphere of oxygen to diffuse tungsten atoms from the needle's tip to its sides.

A photoemission cathode is described in U.S. Paten 4,460,831 issued July 17, 1984 to Oettinger et al, entitled LASER STIMULATED HIGH CURRENT DENSITY PHOTOELECTRON GENERATOR AND METHOD OF MANUFACTURE, wherein there is disclosed a laminated photoemissive cathode employing a sapphire substrate on which compound electron emitting materials, such as those of cesium and compound semiconductors, are placed. The photoemissive surface is applied to the end of an optical fiber into the other end of which laser light is directed.

There have been other efforts in the art to use optical fibers to deliver light to photoelectric surfaces.

European patent EP187087 to d'Humieres et al, dated December 14, 1984, describes a structure wherein an optical fiber feeds into a photocathode to provide a source for a scanning system.

Japanese patent JP60-30230, dated July 29, 1983, discloses a system wherein an optical fiber is connected directly to a photoelectric surface. Electrons are used to actuate a switch.

In two publications, Research Disclosure RD23808 (February 1984), pages 37, 38, and RD255028 (February 1985), page 114, structures are shown wherein the beam from an optical fiber illuminates a photocathode and wherein a plurality of optical fibers are connected to a photocathode.

As the art progressed, awareness developed that brighter photoemission and resistance to degradation usually from environmental factors was desirable.

It has been described, in an article entitled "Laser Photoelectron Sources of High Apparent Brightness" by Gail A. Massey in the IEEE Journal of Quantum Electronics, Vol. QE20, No. 2, February 1984, pages 103 to 105, that the output of a laser striking a very small convex emitter surface of a cathode with a corresponding convex anode can produce a photoemission of very high brightness wherein the energy is sufficient to provide emission from simple materials with 4-6 eV workfunction energies that are resistant to many environmental factors.

While the article provides an indication that practical photocathodes using materials resistant to environmental factors may be employed in electron beam apparatus, there still remains a problem in the art in providing such photoelectron sources in simple structures compatible with the stringent specifications of small signal sensitivity and submicron dimension device production equipment.

The invention is a fibre optic photocathode, useful in achieving the strict dimensional constraints of instrumentation and array use, in which the output of a high intensity light source, such as a laser, is transmitted in the core of a clad optical fibre to the cathode location, where a conducting cathode material, having a work function corresponding to the frequency of the light source, in which the photon energy of the light is slightly above the work function of the material, is positioned essentially in contact with the core of the optical fibre. The photocathode may be coated directly on the optical fibre. The core of ehe optical fibre operates to control the size of the photoemission. The end of the fibre core may further be shaped to increase the extraction field so as to provide an intense optical emission spot. The optical fibre cladding may provide precision advantage in shaping. Electrical connection to the cathode material may be facilitated by connection to a metal coating over the optical fibre cladding or extending the cathode material to an adjacent support.

One way of carrying out the invention is described in detail below with reference to drawings which illustrate only one specific embodiment in which:
- FIG. 1: is a schematic illustration of the fibre optic photocathode and relative position of the associate anode.
- FIG. 2: is a dimensionally correlated graph of light intensity over a surface which will be reflected in the electron emission pattern.
- FIG. 3: is a schematic illustration of a jacketed optical fibre with a flat emission surface.
- FIG. 4: is a schematic illustration of a metal coated fibre with a shaped emission surface.
- FIG. 5: is a schematic illustration of a high intensity light source focused into an optical fibre and with the emission material extended to a supporting member.
- FIG. 6: is a schematic illustration of an array of photocathodes.

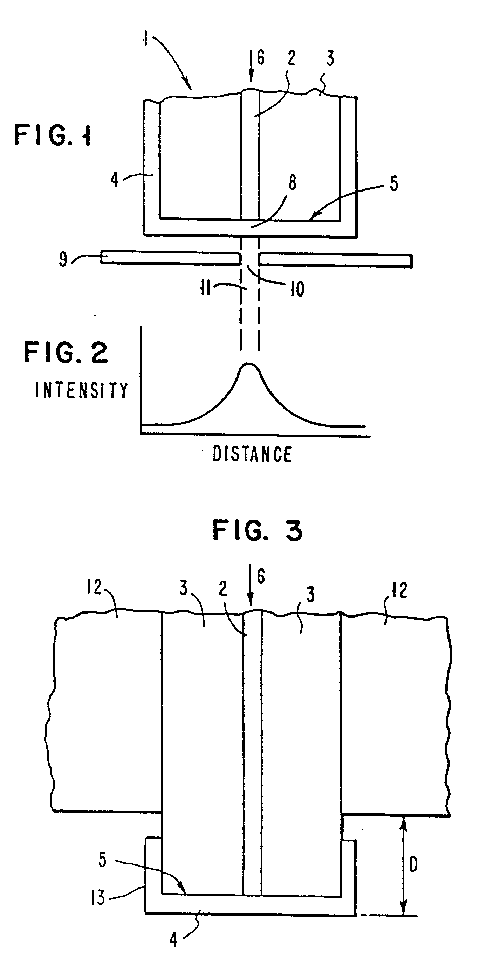

The invention is a fibre optic photocathode wherein referring to FIG. 1, an optical fibre 1 has a core 2 surrounded by cladding 3 with an environmentally resistant photoemissive cathode material 4 across the face 5 of the optical fibre and in contact with at least the core 2. High intensity light, such as from a laser, the photon energy value of which is slightly above the work function of the cathode material 4, is schematically shown by arrow 6 as being introduced into the fibre optic core 2. Under these conditions, in the presence of an extracting field 7 between the emitting portion 8 of the material 4 and anode 9 with an opening 10, a very bright confined beam 11 of photoemitted electrons is produced. Further, under these conditions, the anode 9 may be flat. Still further, the material 4 can be extended past the face 5 to a region for ease of making the cathode electrical contact.

The brightness and directionality of the beam 11 is illustrated in connection with FIG. 2 which is dimensionally correlated with FIG. 1 and shows the localized intensity of the beam across the face 5. In FIG. 2 there is a sharp increase in intensity, many times that of the background level, narrowly confined to the area right under the beam.

Since photocathodes emit electrons in a better defined cone compared with thermionic cathodes and since the structure of the invention permits very precise focusing, a relatively flat anode becomes possible with no significant loss in efficiency.

In accordance with the invention, the photocathode may be coated directly on the end of the optical fibre such as by evaporating, sputtering or plating. or with some loss it can be positioned adjacent to it. Since the cathode is operated in a vacuum but is sensitive to air and the impurities in the vacuum, the work function of the material 4 of the photocathode is of some importance. It is related to the light frequency to the point where visible light frequency to the point where visible light requires a lower work function and the higher work functions require ultra violet. Most metals are in the 4-5 electron volt range, such as copper, nickel, gold, tungsten and aluminum. Clearly, gold would be preferred as it is a good conductor and doesn't oxidize. Further, photoemissive materials with lower work functions would include such compound semiconductors as GaAs, GaP and cesiated photocathode materials to the extend that environmental degradation doesn't interfere with their performance.

The efficiency of a photocathode is generally measured in terms of the number of electrons emitted per unit area. It has been found in accordance with the invention that the thickness of the photocathode 4 in the region 8 is of the order of a few tens of nanometers, where 20nm are generally needed for an electrically continuous film, and 3nm is a minimum corresponding to the escape depth distance in the material chosen for the photocathode. It has further been found, in accordance with the invention, that a factor of 10 improvement in efficiency can be achieved by providing a rough surface film for the element 4 at least in the region 8 and this is ach eved by providing a thin layer of calcium fluroide under the layer of gold on the surface of the cladding and core 2 and 3 of the optical fibre 1 in FIG. 1. In the fibre optic element 1, the smaller sizes are best and a preferred structure would have the core 2 about 3 to 4 microns in diameter with the cladding 3 being about 50 microns thick, providing a fibre optic 1 diameter of about 100 microns. The material of the core 2 is for most purposes a silica based fibre that does not attenuate light significantly although there are some light frequencies that respond better to materials other than silica based. It is important only that the strong light source introduced at 6 into the core 2 not be significantly attenuated until it reaches the face 5.

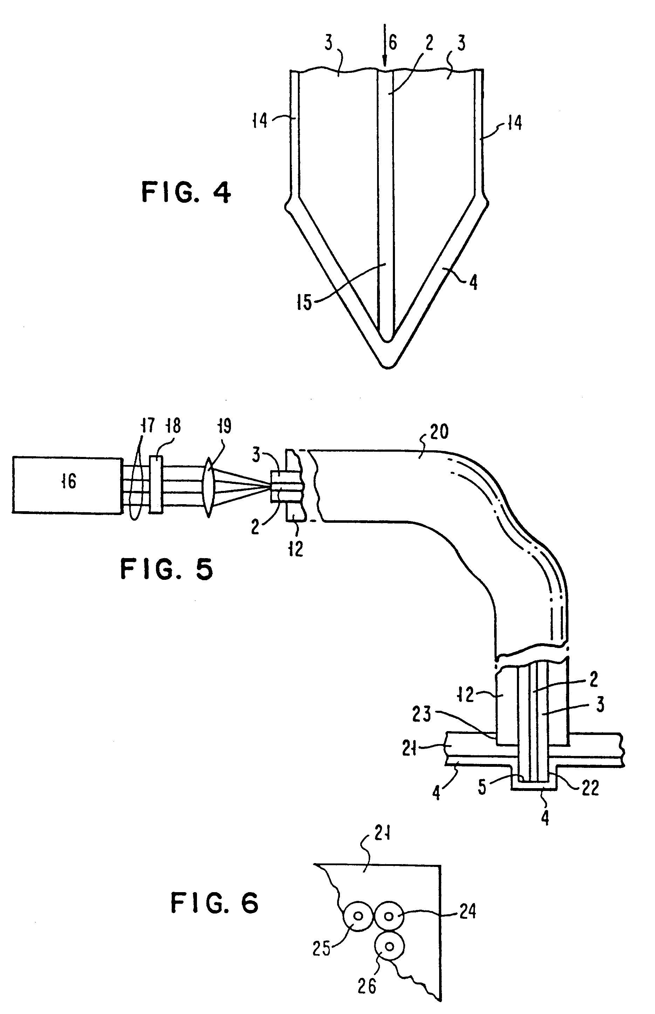

Referring next to FIGS. 3 and 4, in accordance with the invention, certain features of types of optical fibres provide useful advantages.

In FIG. 3 a schematic view of a jacketed type optical fibre is shown.

The fibre has a core 2 of usually silica based material with optical properties generally favorable to the transmission of the light introduced as indicated as arrow 6. Surrounding the core 2 is a region 3 of cladding material again, usually silica based, with optical properties selected to reflect light in the core 2 back into the core 2 at the interface with the cladding 3. Surrounding the cladding 3 is a jacket 12 principally for structural strength and protection. The jacket material 12 is usually plastic. Most longer length fibre optical applications employ jacketed structures.

At the face 5 the cladding 3 and core 2 are constructed to extend beyond the jacket 12 a distance D of about 1 to 2 millimeters. The face 5 is made flat and essentially perpendicular to the length dimension of the core 2 by a scribing and wedging operation known in the art as cleaving. A thin high work function layer 4 of for example 20nm of gold applied by an evaporation process is provided over the face 5. The material is extended along the dimension D in the region 13 to facilitate making the cathode contact.

Referring next to FIG. 4, an illustration is provided of an optical fibre with a metal coating over the cladding and with the emitting portion sharpened to enhance the intensity of the extraction field and therefore the overall brightness of the source.

The core 2 is surrounded by a cladding portion 3 and the cladding 3 in turn is provided with a metal covering 14. The light is introduced as depicted by arrow 6. The combination of the core 2 and the cladding 3 is brought to a point or very small radius at the emitting location 15. The cathode material 4 is placed over both the cladding 3 and the core 2 and extended to the metal cover 14 which permits an easier cathode contact.

The sharpening of the portion 15 is easier with greater overall widths of the fibre 1 because the slope can be more controlled and the smaller the spot at the sharpened region 15, the better the extraction field can draw out greater numbers of electrons per unit area and hence greater brightness. A further advantage is the relative ease of making a continuous coating by not having sharp angles.

It will be apparent to one skilled in the art that within the principles of the invention there will be many variations and substitutions that can be made in using the features of the various types of optical fibres available in the art of which those of FIGS. 3 and 4 are merely representative. For example, in the jacketed type of fibre, if the jacket were to have a conductive coating, the contacting technigue used with the fibre of FIG. 4 could be used.

Referring next to FIG. 5, there is shown a schematic illustration of a high intensity light source focused into an optical fibre of some length and at the emission end the photoemitting cathode material is extended onto a supporting member.

The high intensity light source 16, which may be a laser although coherent light is not essential, has the light 17 therefrom controlled by a modulator 18 and focused in a lens 19 into the core 2 of a jacketed type optical fibre 20. At the focusing location, the lens can be positioned somewhat remote from the core 2 and cladding 3 end of the optical fibre into which the light is being directed. The modulator 18 can be used to turn the light 17 off.

At the emission end, a supporting member 21, such as a flange of metal to facilitate electrical conduction and structural rigidity is provided. An opening 22 through the member 21 is provided having an opening all the way through the side of the cladding 3 and having a counterbore 23 on one side approximately half way through the side of the jacket 12.

The optical fibre 20 is positioned in the counterbore 23 with the core 2 and cladding 3 extending beyond the jacket 12, through the member 21 a distance determined by the desired field with an anode not shown. The photoemis.ion material 4 is applied, such as by bcoating, directly on the cleaved face 5, extending along the side regions, to, and over the face, of the member 21. The optical fibre 20 is then fastened with the jacket 12 in the counterbore 23 and with the cladding 3 and core 2 positioned by the mateiral 4 which has a good electrical contact thereto through the metal member 21.

It is desireable for an optimum photoemission to match the photon energy of the light source 16 with the work function of the material 4. The photon energy Should be slightly above the work function but as the photon energy exceeds the work function the electrons lose directionality and brightness diminishes.

Referring next to FIG. 6, a schematic illustration is provided of a portion of an array of photocathodes as illustrated in FIG. 1. The photocathodes 24, 25 and 26 are positioned in a supporting member 21 as shown in FIG. 5 and each has a core 2 and cladding 3 as shown in the enlarged figures. The schematic illustration of FIG. 6 is viewed from the under side of the photocathode of the invention lies in the fact that the anode can be flat and consequently each photocathode 24, 25 and 26 can be positioned in a supporting member, such as 21 in FIG. 5, so close to a neighbor as to be tangential so that the intercathode distances are very close to the diameter of the core and cladding of the optical fibre.

In the schematic array of FIG. 6, it will be apparent that an advantage lies in the fact that individual ones of the cathodes 24, 25 and 26 can be turned on or off by merely changing the electrical connections to the cathode or by using the shut off capability of the modulator 18 in FIG. 5, whereby the invention provides the ability to selectively choose pixel elements by activating individual fibres and this capability would be useful in electron beam lithography and test technology.

The preferred embodiment would be to use as an ultra violet source the fourth harmonic of a fibre compressed Nd-YAG modelocked laser, resulting in 1 picosecond pulses at 266 nanometers with average power of 3 milliwatts and 100 megahertz repetition rate. The optical fibre has a 3 to 4 micron diameter core, and cladding of about 50 microns so that the total diameter is near 100 microns. The anode 9 is positioned about 1 millimeter from the material 4 and the opening 10 is about 1 millimeter. The work function of a gold film used as the material 4 is within a few tenths of an electron volt of the photon energy. The gold fim 4 is roughened. The system yields efficiencies of 0.2 x 10-3 which in turn corresponds to 6,000 electrons per pulse.

The photocathode of the invention may be applied as a photo electron source for a scanning electron microscope system well known in the art which can be used for high speed testing of such items as integrated circuits. A photo electron microscope employing such photocathode will result in a well defined electron source which can be easily aligned with the column of the microscope. Further, such an electron source decouples any vibration of the laser with respect to the microscope column. In such an application, short lengths of fibre 1, not exceeding a few meters, should be used to prevent modal dispersion of the light pulses and keep electron pulse durations to the order of a picosecond.

In lithography type applications, an intense ultra violet laser, such as an excimer laser, may be used to give an electron source of higher brightness. With such a laser, it becomes possible to adjust the input light to the fibre. Fibre bundles can be used to give shaped beams and to form higher brightness crossove rpoints close to the bundle.

What has been described is a fibre optic photocathode wherein a high intensity light source such as a laser is transmitted in the core of a clad optical fibre to a simple conducting cathode on the end of the optical fibre and, in the presence of a potential between an anode adjacent to the conducting cathode and the cathode, an extraction electrical field provides a beam of electrons.

## Claims

1. A photoemission element comprising in combination:
an optical fibre (1) having at least a core portion (2) surrounded by a cladding portion (3),
means (16) introducing high intensity light (6) into one end of said optical fibre (1), and
a conducting member (4) having a work function proximate to but lower than the photon energy of said light (6) positioned in photoemission proximity with at least said core (2), on the remaining end of said optical fibre (1).

2. The photoemission element of claim 1 wherein said conducting member (4) is in contact with at least said core (2).

3. The photoemission element of claim 1 or 2 wherein said light introduction means includes a laser.

4. The photoemission element of one or more of the preceding claims 1 to 3 wherein said core (2) and said cladding (3) end in a flat surface (5) or are shaped to a point at said core (2).

5. The photoemission element of one or more of the preceding claims 1 to 4 wherein said conducting member (4) is a metal preferably taken from the group of copper, nickel, gold, tungsten and aluminum.

6. The photoemission element of one or more of the preceding claims 1 to 5 wherein said metal (4) is roughened.

7. The phototemission element of one or more of the preceding claims 1 to 4 wherein said conducting member (4) is a material taken from the group of GaAs, GaP and Cesiated photocathode materials.

8. A photocathode comprising in combination details as described in one or more of the preceding claims 1 to 7, further including an anode (9) positioned proximate to said conducting layer (4), having a hole (10) therein aligned with said core (2), and a charge between said conducting layer (4) and said anode (9) of a magnitude to provide an electron beam extraction field for electrons (11) emitted from said conducting layer (4).

9. The photocathode of claim 8 wherein said fibre (20) is positioned in a counterbore (23) of a conductive supporting member (21) and said metal (4) makes contact to both said core (2) and said supporting member (21).

10. The photocathode of claim 8 or 9 wherein said laser (16) is focused through a modulator (18) and a lens (19) into said core (2) of said optical fibre (20).

11. An array of selectively operable photocathodes comprising in combination:
a plurality of photocathode members (24, 25, 26), each member as described in at least one or more of the preceding claims 8 to 10 further comprising
a common flat anode (9) having an electron beam aperture (10) for each said photocathode, and
means positioning each said remaining end of each said fibre proximate to and in alignment with an aperture (10) in said anode (9).

## Patentansprüche

1. Eine Vorrichtung zur Photoemission mit
einem Lichtleiter (1), der Wenigstens einen Kernbereich (2) aufweist, der von einem Mantelbereich (3) umgeben ist,
Mitteln (16), die Licht (6) hoher Intensität in ein Ende des Lichtleiters (1) einkoppeln, und
einem leitfähigen Teil (4), das eine Austrittsarbeit nahe an, aber geringer als die Photonenenergie des Lichts (6) aufweist, und am anderen Ende des Lichtleiters (1) in Photoemissions-Nähe wenigstens zum Kern (2) angeordnet ist.

2. Die Vorrichtung zur Photoemission nach Anspruch 1, wobei das leitfähige Teil (4) wenigstens mit dem Kern (2) in Kontakt steht.

3. Die Vorrichtung zur Photoemission nach Anspruch 1 oder 2, wobei die Mittel zur Lichteinkopplung einen Laser enthalten.

4. Die Vorrichtung zur Photoemission nach einem oder mehreren der Ansprüche 1 bis 3, wobei der Kern (2) und der Mantel (3) in Form einer ebenen Oberfläche (5) enden oder zum Kern (2) hin punktförmig zugespitzt sind.

5. Die Vorrichtung zur Photoemission nach einem oder mehreren der Ansprüche 1 bis 4, wobei das leitfähige Teil (4) aus Metall, vorzugsweise Kupfer, Nickel, Gold, Wolfram oder Aluminium besteht.

6. Die Vorrichtung zur Photoemission nach einem oder mehreren der Ansprüche 1 bis 5, wobei das Metall (4) aufgerauht ist.

7. Die Vorrichtung zur Photoemission nach einem oder mehreren der Ansprüche 1 bis 4, wobei das leitfähige Teil (4) aus GaAs, GaP oder Cäsium-dotierten Photokathoden-Werkstoffen besteht.

8. Eine Photokathode mit Merkmalen, die in einem oder mehreren der Ansprüche 1 bis 7 beschrieben sind, sowie zusätzlich einer Anode (9), die in der Nähe der leitfähigen Schicht (4) angeordnet ist und ein Loch (10) aufweist, das mit dem Kern (2) fluchtet, sowie einer Aufladung zwischen der leitfähigen Schicht (4) und der Anode (9) von einer Größe, daß ein Elektronenstrahl-Absaugfeld für die von der leitfähigen Schicht (4) emittierten Elektronen (11) zur Verfügung steht.

9. Die Photokathode nach Anspruch 8, wobei die Faser (20) in einer Senkung (23) in einem leitfähigen tragenden Teil (21) angeordnet ist und das Metall (4) mit dem Kern (2) und mit dem tragenden Teil (21) Kontakt hat.

10. Die Photokathode nach Anspruch 8 oder 9, wobei der Laser (16) durch einen Modulator (18) und eine Linse (19) hindurch in den Kern (2) der Lichtleiter (20) hineinfokussiert wird.

11. Ein Array aus selektiv betreibbaren Photokathoden mit
einer Mehrzahl von Photokathoden (24, 25, 26), von denen jede Merkmale nach wenigstens einem der Ansprüche 8 bis 10 aufweist,
sowie mit einer gemeinsamen ebenen Anode (9), die für jede Photokathode eine Elektronenstrahl-Blende (10) aufweist, und
Mittel, um jedes verbleibende Ende von jeder Faser nahe an und fluchtend mit einer Blende (10) der Anode (9) anzuordnen.

## Revendications

1. Elément à photoémission comprenant en combinaison :
une fibre optique (1) ayant au moins une portion de coeur optique (2) entourée par une portion de gainage (3),
un moyen (16) introduisant une lumière à haute intensité (6) dans une extrémité de la fibre optique (1), et
un élément conducteur (4) ayant une fonction de travail proche mais inférieure à l'énergie en photons de la lumière (6) positionnée en photoémission proche avec au moins le coeur optique (2) sur l'extrémité restante de la fibre optique (1).

2. Elément à photoémission selon la revendication 1, dans lequel l'élément conducteur 4 est en contact avec au moins le coeur optique 2.

3. Elément à photoémission selon la revendication 1 ou 2, dans lequel le moyen d'introduction de la lumière comporte un laser.

4. Elément à photoémission selon une des revendications ou plusieurs des revendications précédentes 1 à 3, dans lequel le coeur optique (2) et le gainage (3) se terminent en une surface plate (5) ou sont formés en un point au niveau du coeur optique (2).

5. Elément à photoémission selon une des revendications ou plusieurs des revendications précédentes 1 à 3, dans lequel l'élément conducteur (4) est un métal de préférence pris dans le groupe constitué du cuivre, nickel, or, tungstène et aluminium.

6. Elément à photoémission selon une des revendications ou plusieurs des revendications précédentes 1 à 5, dans lequel le métal (4) est rendu rugueux.

7. Elément à photoémission selon une des revendications ou plusieurs des revendications précédentes 1 à 4, dans lequel l'élément conducteur (4) est un matériau qui est pris dans le groupe constitué des GaAs, GaP et des matériaux de photocathode au Césium.

8. Photocathode comprenant en combinaison les détails comme décrits dans une ou plusieurs des revendications précédents 1 à 7, comportant de plus une anode (9) placée proche de la couche conductrice (4), ayant un trou (10) dans celle-ci aligné avec le coeur optique (2), et une charge entre la couche conductrice (4) et l'anode (9) d'une amplitude suffisante pour procurer un champs d'extraction des faisceaux d'électrons pour les électrons (11) émis à partir de la couche conductrice (4).

9. Photocathode selon la revendication 8, dans laquelle la fibre (20) est positionnée dans un chambrage (23) d'un élément de support conducteur (21) et le métal (4) établit le contact à la fois avec le coeur optique (2) et avec l'élément du support (21).

10. Photocathode selon la revendication 8 ou 9, dans laquelle le laser (16) est focalisé à travers un modulateur (18) et une lentille (19) dans le coeur optique (2) de la fibre optique (20).

11. Réseau de photocathodes sélectivement actionnables comprenant en combinaison :
une pluralité d'éléments de photocathode (24, 25, 26), chaque élément comme décrit dans au moins une ou plusieurs des revendications précédentes 8 à 10 comprenant de plus une anode plate commune (9) ayant une ouverture de faisceaux d'électrons (10) pour chaque photocathode, et un moyen positionnant chaque extrémité restante de chaque fibre proche et en alignement avec l'ouverture (10) dans ladite anode (9).
